# EUROPEAN PATENT APPLICATION

(11) **EP 4 600 666 A1**
(43) Date of publication of application: **13.08.2025**
(21) Application number: 23875191.1
(22) Date of filing: 04.10.2023
(51) Int. Cl.: G01R 19/32, G01R 15/18, G01R 15/14, G01R 17/20, G01R 19/00, G01K 1/02, G01K 1/14, H01F 27/42, H01F 27/00, H01F 38/30

(54) **LOW-POWER CURRENT TRANSFORMER TO WHICH TEMPERATURE COMPENSATION IS APPLIED, AND TEMPERATURE COMPENSATION METHOD THEREFOR**

(30) Priority: 05.10.2022 KR 20220127302
(71) Applicant: Hyosung Heavy Industries Corporation, Seoul 04144 (KR)
(72) Inventor: KIM, Do Jin, Changwon-si Gyeongsangnam-do 51526 (KR); KIM, Jong Wang, Anyang-si Gyeonggi-do 14067 (KR)
(74) Representative: Viering, Jentschura & Partner mbB Patent- und Rechtsanwälte
(86) International application number: PCT/KR2023/015201
(87) International publication number: WO 2024/076127

(57) **Abstract**

The present invention relates to a low-power current transformer (LPCT) with temperature compensation applied and a temperature compensation method thereof, wherein the LPCT is capable of increasing measurement values according to changes in temperature of the LPCT and satisfies temperature requirements of IEC61869-6 by attaching and calibrating temperature sensors around the LPCT.

The LPCT with temperature compensation applied in accordance with the present invention comprises a current sensor with a first temperature sensor for sensing current of the LPCT, and a secondary converter with a second temperature sensor for performing second conversion to transmit measured current information to a merging unit.

## Description

### TECHNICAL FIELD OF THE INVENTION

The present invention relates to a low-power current transformer with temperature compensation applied and a temperature compensation method thereof, and more particularly, to the low-power current transformer with temperature compensation applied and the temperature compensation method thereof to increase reliability of measurement values according to changes in temperature of the low-power current transformer by compensating by changes in temperature thereof.

### BACKGROUND OF THE INVENTION

In the past, substations used a simple communication method of transmitting one-to-one signals by physical electric cables to monitor electric power equipment required for the process of electric power transmission, but modern substations are operated with a digital system that considers all signals for monitoring and controlling electric power equipment as sharable data.

Since it is the most important for such digitalized substations to be capable of sharing data between devices through a network, most of power generation companies and producers around the world have built such systems based on international standards such as IEC 61850.

As an internationally recognized communication standard protocol provided by the International Electrotechnical Commission (IEC), IEC 61850 provides generally applied rules for communications between medium-voltage devices and high-voltage switchgears and defines required system requirements.

For an instance, U.S. Patent No. 17313166 proposed a system for providing output of a low-power voltage transformer with a capacitor disposed within an insulating body around a conductor configured to electrically couple sensors, thereby forming a capacitive current divider.

However, even in this case, it was difficult to meet the requirements defined in IEC61869-6 as a test standard for verifying performance, durability, and safety of the low-power voltage transformer due to the unstable output of the low-power voltage transformer caused by changes in temperature.

### DETAILED EXPLANATION OF THE INVENTION

### OBJECTS OF THE INVENTION

The object of the present invention is to provide a low-power current transformer (LPCT) with temperature compensation applied and a temperature compensation method thereof, wherein the LPCT is capable of increasing reliability of measurement values according to changes in temperature of the LPCT.

The other object of the present invention is to provide a LPCT with temperature compensation applied and a temperature compensation method thereof, wherein the LPCT satisfies temperature requirements of IEC61869-6 by attaching and calibrating a temperature sensor around the LPCT.

### MEANS OF SOLVING THE PROBLEM

A low-power current transformer (LPCT) with temperature compensation applied in accordance with the present invention may comprise: a current sensor with a first temperature sensor for sensing current of the LPCT; and a secondary converter with a second temperature sensor for performing second conversion to transmit measured current information to a merging unit.

Herein, the current sensor may include: a coil for sensing current; a printed circuit board (PCB) in which the coil is pattern-printed; and a return coil in which a part of the coil is returned through a hole provided inside the PCB.

In addition, multiple PCB coils may be connected with each other in series.

Furthermore, a material whose coefficient of thermal expansion is less than 90ppm/°C may be applied to a PCB.

Meanwhile, the secondary converter may include: a controller for deriving correction coefficients of size and phase of output of the current sensor caused by changes in temperature based on temperature measured by the first temperature sensor attached to the current sensor and the second temperature sensor built in the secondary converter; a current divider for dividing output current of the current sensor based on control of the controller; and a phase controller for controlling phase of output of the current divider based on control of the controller.

At the time, the controller may control the current divider and the phase controller by deriving correction coefficients of size and phase caused by changes in temperature that meet requirements of IEC61869-6.

Besides, the current divider may divide current based on a digital potentiometer.

In addition, the phase controller may control phase based on a digital potentiometer.

Meanwhile, a temperature compensation method of a LPCT with temperature compensation applied in accordance with the present invention may comprise: a first temperature sensing step of a first temperature sensor attached to a current sensor measuring temperature of the current sensor; a second temperature sensing step of a second temperature sensor built in a secondary converter measuring temperature inside the secondary converter; a temperature correction coefficients-deriving step of a controller deriving correction coefficients of size and phase of output of the current sensor caused by changes in temperature based on the temperature measured by the first temperature sensor and the second temperature sensor; a gain controlling step of the controller dividing output current of the current sensor based on the correction coefficients and controlling gain; and a phase controlling step of the controller controlling output phase of the current divider based on the correction coefficients.

At the time, correction coefficients of size and phase caused by changes in temperature that meet requirements of IEC61869-6 may be derived at the temperature correction coefficients-deriving step.

### EFFECTS OF THE INVENTION

A low-power current transformer (LPCT) with temperature compensation applied and a temperature compensation method thereof in accordance with the present invention have an effect of increasing reliability of measurement values according to changes in temperature of the LPCT.

In addition, a LPCT with temperature compensation applied and a temperature compensation method thereof in accordance with the present invention have an effect of satisfying temperature requirements of IEC61869-6 by attaching and calibrating a temperature sensor around the LPCT.

### BRIEF DESCRIPTION OF THE DRAWINGS

Fig. 1 is a component block diagram showing a low-power current transformer with temperature compensation applied in accordance with one example embodiment of the present invention.
Fig. 2 is a block diagram more specifically illustrating a current sensor in Fig. 1.
Fig. 3 is a component block diagram more specifically illustrating a secondary converter in Fig.1.
Fig. 4 is a flow chart showing a temperature compensation method of a low-power current transformer with temperature compensation applied in accordance with one example embodiment of the present invention.

### DETAILED DESCRIPTION OF THE PREFERRED EMBODIMENTS

The specific example embodiments of the present invention are explained by referring to attached drawings below.

Upon the explanation of the present invention, terms such as "first," "second," etc. may be used to explain a variety of components but the components may not be limited by such terms. The terms are used only for the purpose of distinguishing one component from another. For example, a first component may be named as a second component without being beyond the scope of the rights of the present invention and similarly, even a second component may be named as a first one.

If it is mentioned that a component is connected or linked to another component, it may be understood that the component may be directly connected or linked to the another component but also a third component may exist in between them.

The terms used in this specification are used only to explain specific examples of embodiments and they are not intended to limit the present invention. Unless a context clearly indicates a different meaning, any reference to singular may include plural ones.

In this specification, terms such as include or equip are used to indicate that there are features, numbers, steps, operations, components, parts, or combinations thereof, and it can be understood that existence or one or more different features, numbers, steps, operations, components, parts, or combinations thereof are not precluded.

Besides, for clearer explanation, shapes, sizes, etc. of elements in drawings may be exaggerated.

By referring to drawings attached below, a low-power current transformer (LPCT) with temperature compensation applied and a temperature compensation method thereof in accordance with the present invention are explained in more detail.

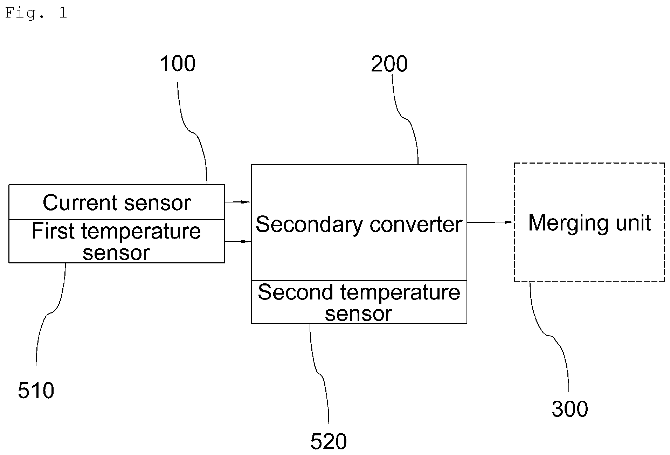

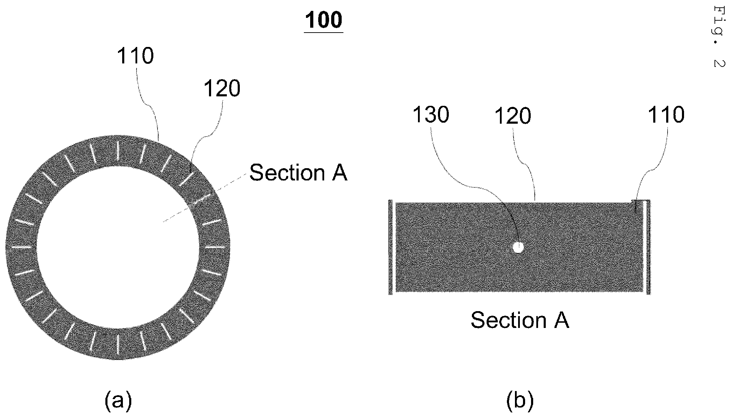

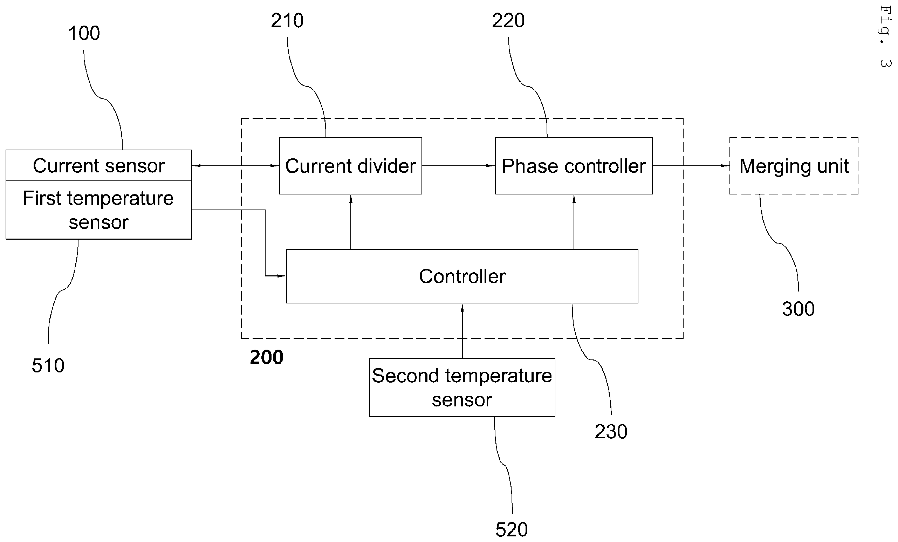

Fig. 1 is a component block diagram showing a LPCT with temperature compensation applied in accordance with one example embodiment of the present invention, and Figs. 2 and 3 are specific block diagrams to make more detailed explanation.

By referring to Figs. 1 to 3, a LPCT with temperature compensation applied in accordance with one example embodiment of the present invention is explained below.

A LPCT necessary for digital substations requires an accuracy class 0.2S even in operating temperature conditions between -40°C and 60°C. Due to changes in permittivity of SF gas in gas insulated switchgear (GIS) and changed values of an operational amplifier and passive elements of a secondary converter caused by changes in operating temperature, the output voltage of the LPCT fluctuates.

In general, it is impossible to satisfy an accuracy class 0.2S without separate temperature compensation. Accordingly, it is necessary to minimize output voltage due to temperature and to have a separate temperature compensation circuit to satisfy measuring accuracy required by a standard IEC61869-6.

Herein, for an accuracy unit S represents special and magnitude error (%), and phase error (minute) may be named as one group.

For example, accuracy class 0.2S for a LPCT defined in the standard IEC61869-6 means accuracy satisfying all the error rates of 0.75%, 0.35%, 0.2%, 0.2%, and 0.2% under the conditions of 1%, 5%, 20%, 100% of Current Iₚᵣ, and Kpcr x Iₚᵣ, respectively.

To solve afore-mentioned problems, the present invention performs temperature compensation by attaching sensors that measure temperature, respectively, to a LPCT and a secondary converter 200.

To this end, by referring to Fig. 1, a LPCT with temperature compensation applied in accordance with one example embodiment of the present invention comprises: a current sensor 100 for sensing current of the LPCT while a first temperature sensor 510 is attached to it; and a secondary converter 200 for performing second conversion to transmit measured current information to a merging unit 300 while a second temperature 520 is attached to it; and at this time, accuracy class 0.2S can be accomplished through temperature compensation performed by the secondary converter 200.

Fig. 2 is a block diagram more specifically illustrating the current sensor 100 in Fig. 1.

As can be seen in Fig. 2, the current sensor 100 includes: coils 120 for sensing current; a printed circuit board (PCB) 110 in which the coil is pattern-printed; and a return coil 130 in which a part of the coil 120 is returned through a hole provided inside the PCB 110.

At the time, while the coils 120 on the multiple PCBs 110 may be connected with each other in series, the last coil may become returned, thereby forming a Rogowski coil.

Meanwhile, a material whose coefficient of thermal expansion is less than 90ppm/°C for normal plastic may be applied to the PCB 110 in accordance with the present invention so that it cannot be sensitive to changes in temperature. For example, a coefficient of thermal expansion of a PCB in accordance with the present invention may be set to be 17ppm/°C, which is a value approximately five times lower than 90ppm°C of MC Nylon as a kind of normal plastic. Through this, the present invention has an effect of being capable of minimizing fluctuation of output voltage caused by changes in temperature.

Fig. 3 is a component block diagram more specifically illustrating the secondary converter 200 in Fig.1.

As can be seen in Fig. 3, the secondary converter 200 includes: a controller 230 for deriving correction coefficients of size and phase of output of the current sensor 100 caused by changes in temperature based on temperature measured by the first temperature sensor 510 attached to the current sensor 100 and the second temperature sensor 520 built in the secondary converter 200; a current divider 210 for dividing output current of the current sensor 100 based on control of the controller 230; and a phase controller 220 for controlling output phase of the current divider 210 based on control of the controller 230.

At this time, the controller 230 derives correction coefficients of size and phase caused by changes in temperature that meet requirements of IEC61869-6 and controls the current divider 210 and the phase controller 230 by using a digital potentiometer.

Herein, to derive correction coefficients, the controller 230 may derive a look-up table based on temperature measured by the first temperature sensor 510 and the second temperature sensor 520 and actual voltage of the LPCT, and apply results obtained through regression analysis or machine learning.

Accordingly, by attaching sensors for measuring temperature of the current sensor 100 and the secondary converter 200 and deriving temperature correction coefficients that can satisfy a temperature cycling test under the standard IEC61869-6, the LPCT with temperature compensation applied in accordance with the present invention may secure 0.2S class accuracy by performing temperature compensation based thereon.

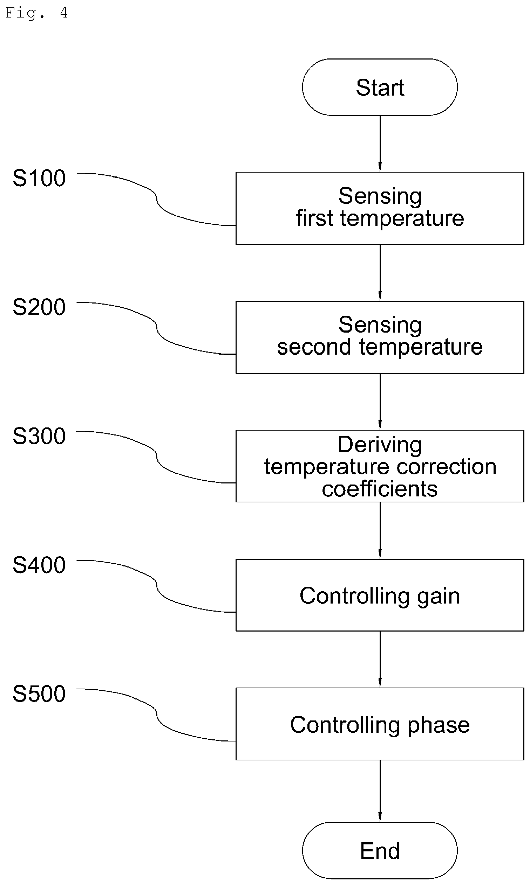

Fig. 4 is a flow chart showing a temperature compensation method of a LPCT with temperature compensation applied in accordance with one example embodiment of the present invention

As can be seen in Fig. 4, a temperature compensation method of a LPCT with temperature compensation applied comprises: a first temperature sensing step S100 of a first temperature sensor 510 attached to a current sensor 100 measuring temperature of the current sensor 100; a second temperature sensing step S200 of a second temperature sensor 520 built in a secondary converter 200 measuring temperature inside the secondary converter 200; a temperature correction coefficients-deriving step S300 of a controller 230 deriving correction coefficients of size and phase of output of the current sensor 100 caused by changes in temperature based on the temperature measured by the first temperature sensor 510 and the second temperature sensor 520; a gain controlling step S400 of the controller 230 dividing output current of the current sensor 100 based on the correction coefficients and controlling gain; and a phase controlling step S500 of the controller 230 controlling output phase of the current divider 210 based on the correction coefficients.

Herein, correction coefficients of size and phase caused by changes in temperature that meet requirements of IEC61869-6 are derived at the temperature correction coefficients-deriving step S300.

Besides, to derive correction coefficients, the controller 230 may derive a look-up table based on temperature measured by the first temperature sensor 510 and the second temperature sensor 520 and actual voltage of the LPCT, and apply results obtained through regression analysis or machine learning.

By attaching sensors for measuring temperature of the current sensor 100 and the secondary converter 200 and deriving temperature correction coefficients that can satisfy a temperature cycling test under the standard IEC61869-6, the LPCT with temperature compensation applied and the temperature compensation method thereof in accordance with the present invention, therefore, may secure 0.2S class accuracy by performing temperature compensation based thereon.

Herein, the accuracy unit S represents special and magnitude error (%), and phase error (minute) may be named as one group. Since this has been explained above, detailed explanation is omitted.

As seen above, the LPCT with temperature compensation applied and the temperature compensation method thereof in accordance with the present invention may increase reliability of measurement values according to changes in temperature of the LPCT and satisfy the temperature requirements of IEC61869-6 by attaching and calibrating temperature sensors around the LPCT.

What has been mentioned above includes one or more example embodiments. Of course, it may be recognized that they cannot describe all possible combinations of components or methods for the purpose of explaining afore-mentioned example embodiments but they may be added or replaced with a lot of additional combinations of various example embodiments by those skilled in the art. Accordingly, the explained example embodiments include all alternatives, modifications, and alternations within the intention and scope of what is claimed as attached below.

### Industrial Availability

The present invention relates to a LPCT with temperature compensation applied and a temperature compensation method thereof, and they are available in a field of current transformers.

## Claims

1. A low-power current transformer (LPCT) with temperature compensation applied, comprising:
(a) a current sensor with a first temperature sensor for sensing current of the LPCT; and
(b) a secondary converter with a second temperature sensor for performing second conversion to transmit measured current information to a merging unit.

2. The LPCT of Claim 1, wherein the current sensor includes: a coil for sensing current; a printed circuit board (PCB) in which the coil is pattern-printed; and a return coil in which a part of the coil is returned through a hole provided inside the PCB.

3. The LPCT of Claim 2, wherein the coils on the multiple PCBs are connected with each other in series.

4. The LPCT of Claim 2, wherein a material whose coefficient of thermal expansion is less than 90ppm/°C is applied to the PCB.

5. The LPCT of Claim 1, wherein the secondary converter includes: a controller for deriving correction coefficients of size and phase of output of the current sensor caused by changes in temperature based on temperature measured by the first temperature sensor attached to the current sensor and the second temperature sensor built in the secondary converter; a current divider for dividing output current of the current sensor based on control of the controller; and a phase controller for controlling output phase of the current divider based on control of the controller.

6. The LPCT of Claim 5, wherein the controller controls the current divider and the phase controller by deriving correction coefficients of size and phase caused by changes in temperature that meet requirements of IEC61869-6.

7. The LPCT of Claim 5, wherein the current divider divides current based on a digital potentiometer.

8. The LPCT of Claim 5, wherein the phase controller controls phase based on a digital potentiometer.

9. A temperature compensation method of a LPCT with temperature compensation applied, comprising:
a first temperature sensing step of a first temperature sensor attached to a current sensor measuring temperature of the current sensor;
a second temperature sensing step of a second temperature sensor built in a secondary converter measuring temperature inside the secondary converter;
a temperature correction coefficients-deriving step of a controller deriving correction coefficients of size and phase of output of the current sensor caused by changes in temperature based on the temperature measured by the first temperature sensor and the second temperature sensor;
a gain controlling step of the controller dividing output current of the current sensor based on the correction coefficients and controlling gain; and
a phase controlling step of the controller controlling output phase of the current divider based on the correction coefficients.

10. The method of Claim 9, wherein correction coefficients of size and phase caused by changes in temperature that meet requirements of IEC61869-6 are derived at the temperature correction coefficients-deriving step.
